# EUROPÄISCHE PATENTSCHRIFT

(11) **EP 2 652 810 B1**
(45) Veröffentlichungstag und Bekanntmachung des Hinweises auf die Patenterteilung: **11.08.2021**
(21) Anmeldenummer: 11794750.7
(22) Anmeldetag: 13.12.2011
(51) Int. Cl.: H01L 51/56

(54) **VERFAHREN ZUR HERSTELLUNG EINER STRAHLUNGSEMITTIERENDEN ORGANISCH-ELEKTRONISCHEN VORRICHTUNG**
METHOD OF FORMING A RADIATION-EMITTING ORGANIC-ELECTRONIC DEVICE
PROCÉDÉ DE FABRICATION D'UN DISPOSITIF ÉLECTRONIQUE ORGANIQUE D'ÉMISSION DE RAYONNEMENT

(30) Priorität: 17.12.2010 DE 102010054893
(43) Veröffentlichungstag der Anmeldung: 23.10.2013
(73) Patentinhaber: OSRAM OLED GmbH, 93055 Regensburg (DE); Fraunhofer-Gesellschaft zur Förderung der angewandten Forschung e.V., 80686 München (DE)
(72) Erfinder: RIEGEL, Nina, 93105 Tegernheim (DE); SETZ, Daniel, Steffen, 71034 Böblingen (DE); FRISCHEISEN, Jörg, 86830 Schwabmünchen (DE); BRÜTTING, Wolfgang, 86159 Augsburg (DE); DOBBERTIN, Thomas, 93051 Regensburg (DE); KRUMMACHER, Benjamin, Claus, 93051 Regensburg (DE); FLÄMMICH, Michael, 07745 Jena (DE); HEUSER, Karsten, 91056 Erlangen (DE); DANZ, Norbert, 07743 Jena (DE)
(74) Vertreter: Epping - Hermann - Fischer
(86) Internationale Anmeldenummer: PCT/EP2011/072632
(87) Internationale Veröffentlichungsnummer: WO 2012/080267

(56) Entgegenhaltungen:
- EP-A1- 2 001 065
- US-A1- 2009 218 561
- US-B1- 7 282 586
- None

## Beschreibung

Die vorliegende Erfindung betrifft ein Verfahren zur Herstellung einer strahlungsemittierenden organisch-elektronischen Vorrichtung mit gegenüber dem Stand der Technik verbesserter Effizienz, bei dem aus Materialien mit anisotroper Molekülstruktur unter thermodynamischer Kontrolle eine Emitterschicht der organisch-elektronischen Vorrichtung gebildet wird.

In strahlungsemittierenden organisch-elektronischen Vorrichtungen, insbesondere in organischen Leuchtdioden (OLEDs) wird die generierte Strahlung nur zum Teil direkt ausgekoppelt. Folgende Verlustkanäle wurden beobachtet: wellenleitende Effekte des transparenten Substrats (das im Strahlengang der emittierten Strahlung angeordnet ist), wellenleitende Effekte in den organischen Schichten und der transparenten Elektrode (die im Strahlengang der emittierten Strahlung angeordnet ist), Absorptionsverluste (aufgrund der Materialien, durch die emittierte Strahlung hindurchtritt) und die Ausbildung von Oberflächenplasmonen, insbesondere an einer metallischen Elektrode (beispielsweise der Kathode).

Die Druckschrift EP 2 001 065 A1 offenbart ein organisches elektrolumineszierendes Bauelement.

Es ist eine Aufgabe der vorliegenden Erfindung, ein Verfahren zur Herstellung einer strahlungsemittierenden elektronischen Vorrichtung anzugeben, bei der die Effizienz gegenüber dem Stand der Technik verbessert ist und insbesondere die Verluste durch zumindest einen der genannten Verlustkanäle vermindert sind.

Diese Aufgabe wird durch das Verfahren zur Herstellung einer strahlungsemittierenden organisch-elektronischen Vorrichtung gemäß dem unabhängigen Anspruch gelöst. Unteransprüche, die Beschreibung und die Zeichnungen lehren vorteilhafte Ausführungsformen und Weiterbildungen hiervon.

Gemäß einer Ausführungsform umfasst das Verfahren zur Herstellung einer strahlungsemittierenden organisch-elektronischen Vorrichtung die folgenden Schritte:
A) ein phosphoreszenter Emitter mit einer anisotropen Molekülstruktur und ein Matrixmaterial werden bereitgestellt;
B) eine erste Elektrodenschicht wird auf ein Substrat aufgebracht;
C) auf der ersten Elektrodenschicht wird eine Emitterschicht unter thermodynamischer Kontrolle aufgebracht, wobei der phosphoreszente Emitter und das Matrixmaterial im Vakuum verdampft werden und auf der Elektrodenschicht abgeschieden werden; hierbei erfolgt durch die thermodynamische Kontrolle eine anisotrope Ausrichtung der Moleküle des phosphoreszenten Emitters; und wobei die thermische Kontrolle erfolgt, indem nach und/oder während dem Abscheidungsschritt und vor Abscheiden einer weiteren Schicht die abgeschiedene Emitterschicht auf eine gegenüber Raumtemperatur erhöhte Temperatur zwischen 30 °C und 100 °C gebracht wird oder auf einer derartigen Temperatur gehalten wird,
D) eine zweite Elektrodenschicht wird auf der Emitterschicht aufgebracht.

Unter einer anisotropen Molekülstruktur wird im Rahmen der vorliegenden Anmeldung verstanden, dass die eingesetzten Moleküle keine im Wesentlichen kugelige Molekülstruktur ausbilden, sondern eine eher langgestreckte Molekülstruktur. Um dies zu erreichen, weisen die phosphoreszenten Emitter insbesondere zumindest zweierlei unterschiedliche Liganden auf (insbesondere Liganden die sich hinsichtlich ihrer an das Zentralatom koordinierenden Atome unterscheiden) oder weisen eine quadratisch-planare Umgebung des Zentralatoms auf.

Im Rahmen der vorliegenden Erfindung kann eine erste Schicht, die "auf" einer zweiten Schicht angeordnet oder aufgebracht ist, bedeuten, dass die erste Schicht unmittelbar in direktem mechanischen und/oder elektrischen Kontakt auf der zweiten Schicht angeordnet oder aufgebracht ist. Weiterhin kann auch ein mittelbarer Kontakt bezeichnet sein, bei dem weitere Schichten zwischen der ersten Schicht und der zweiten Schicht angeordnet sind.

Unter einem Aufbringen unter thermodynamischer Kontrolle wird anmeldungsgemäß verstanden, dass bei der Abscheidung der Emittermoleküle und der Moleküle des Matrixmaterials keine willkürliche Ausrichtung der abgeschiedenen Moleküle erfolgt, sondern dass vielmehr die Ausrichtung zumindest teilweise in einer Vorzugsrichtung stattfindet. Damit geht einher, dass auch die Übergangsdipolmomente der Emittermoleküle in der Summe eine anisotrope Verteilung innerhalb der Matrix aufweisen, die insbesondere dadurch charakterisiert ist, dass mehr Übergangsdipolmomente parallel zur Schichtebene der Emitterschicht ausgerichtet sind als Übergangsdipolmomente, die orthogonal hierzu ausgerichtet sind. Die Übergangsdipolmomente weisen eine bestimmte Orientierung im emittierenden Molekül auf und sind deshalb relevant, weil der Emissionsprozess ein Dipol-Übergang ist. Die thermodynamische Kontrolle erfordert also, dass anders als bei der kinetischen Kontrolle ein Emittermolekül nicht automatisch in der Position "eingefroren" wird, in der es erstmalig mit der Oberfläche, auf der es abgeschieden wird, in Wechselwirkung tritt, sondern dass vielmehr während der Abscheidung oder in einem späteren Schritt eine Umorientierung erfolgen kann, bei der eine Ausrichtung benachbarter Moleküle erfolgt, wobei eine thermodynamisch günstigere Konfiguration eingenommen werden kann. Eine derartige anisotrope Ausrichtung der Emittermoleküle ist insbesondere dann möglich, wenn sowohl für den Emitter als auch für das Matrixmaterial Ausgangsmaterialien ausgewählt werden, die eine anisotrope Molekülstruktur besitzen.

Erfindungsgemäß wurde also erkannt, dass durch die Ausgangsmaterialien mit anisotroper Molekülstruktur Emitterschichten erzeugt werden können, in denen die einzelnen Emittermoleküle und damit auch die Übergangsdipolmomente der emittierenden Moleküle eine Vorzugsausrichtung aufweisen. Im Idealfall liegen die Emittermoleküle im Wesentlichen parallel ausgerichtet vor, wobei dann beobachtet wird, dass fast kein Verlust durch Plasmonen auftritt. Der Verlustkanal "Effizientverlust durch Plasmonenauskopplung" wird somit teilweise versperrt, sodass letztlich die Gesamteffizienz deutlich steigt. Durch die im Wesentlichen vorhandene Vorzugsausrichtung der Emittermoleküle, die vorzugsweise parallel zur Substratoberfläche ausgerichtet sind, kann nur in beschränktem Umfang eine Wechselwirkung des bei der Rekombination von Elektron und Loch entstehenden elektromagnetischen Felds mit den Plasmonen der Metallschicht erfolgen.

Unter einem Plasmon wird eine Ladungsträgerdichteschwingung in der Metallschicht der ersten Elektrode verstanden. Insbesondere kann ein von einem rekombinierenden Exziton erzeugtes elektromagnetisches Feld freie Ladungsträger, insbesondere Elektronen, in der Metallschicht einer Elektrode zu Ladungsträgerdichteschwingungen anregen. Mit anderen Worten kann das bei der Rekombination eines Exzitons entstehende elektromagnetische Feld an ein Plasmon in der Metallschicht der Elektrode koppeln, sodass die Rekombinationsenergie zumindest teilweise auf das Plasmon übergehen kann.

Insbesondere bezeichnen Plasmonen (präziser:
Oberflächenplasmonen) hierbei longitudinale Ladungsträgerdichteschwingungen, die parallel zur Erstreckungsebene einer Oberfläche der Metallschicht einer Elektrode an dieser Oberfläche auftreten.
Oberflächenplasmonen können dabei insbesondere an der der Emitterschicht zugewandten Oberfläche der Metallschicht dieser Elektrode erzeugt werden.

Gemäß einer nicht beanspruchten Ausführungsform des Verfahrens erfolgt die thermodynamische Kontrolle in Schritt C), indem eine Aufwachsrate gewählt wird, die kleiner oder gleich als 0,5 nm/s ist. Insbesondere kann die Aufwachsrate kleiner als 0,2 nm/s sein und ist häufig auch kleiner als 0,1 nm/s. Oft ist die Aufwachsrate kleiner als 0,05 nm/s; sie kann beispielsweise auch kleiner als 0,025 nm/s sein. Bei einer Aufwachsrate von 0,05 nm/s beträgt die Abscheidungszeit für eine 10 nm dicke Emitterschicht dann etwa 200 s. Unter der Aufwachsrate ist dabei die Geschwindigkeit zu verstehen, mit der in Schritt C) auf der ersten Elektrodenschicht die Emitterschicht abgeschieden wird. Im Regelfall ist die dabei abgeschiedene Stoffmenge beispielsweise im Wesentlichen identisch mit der aus einer Vorlage verdampften Stoffmenge. Eine besonders langsame Aufwachsrate kann beispielsweise dann gewählt werden, wenn die Materialien für die Emitterschicht keine erhöhte Temperatur des zu beschichtenden Substrats zulassen (vergleiche nachfolgende Ausführungsform).

Erfindungsgemäß wird die thermodynamische Kontrolle in Schritt C) dadurch erreicht, dass nach und/oder während dem Abscheidungsschritt (Schritt C)) die abgeschiedene Schicht vor dem Abscheiden weiterer Schichten einer Temperaturbehandlung unterworfen wird. Die Emitterschicht wird auf eine gegenüber Raumtemperatur erhöhte Temperatur zwischen 30 °C und 100 °C gebracht oder auf einer derartigen Temperatur gehalten. Auf die abgeschiedene Schicht wirken also entweder während der Abscheidung erhöhte Temperaturen ein und/oder nach vollständiger Abscheidung der Emitterschicht und vor Abscheiden einer weiteren Schicht erfolgt ein Tempern der abgeschiedenen Schicht. Bei einer derartigen Temperaturbehandlung wird die Schicht also in einen Zustand gebracht, bei dem eine Umorientierung, insbesondere der Emittermoleküle, möglich ist, sodass eine Ausrichtung der Emittermoleküle erfolgen kann. Dieser ausgerichtete Zustand kann dann durch die Abkühlung nachfolgend eingefroren werden. Die Temperaturbehandlung kann hierbei insbesondere erfolgen, indem die Emitterschicht beziehungsweise die substratseitig angrenzende Schicht (beispielsweise über ein beheiztes Substrat) erwärmt wird. Die Emitterschicht wird dabei auf eine Temperatur zwischen 30°C und 100 °C gebracht. Wesentlich hierbei ist, dass die gewählten Temperaturen keine Beschädigung der aufzubringenden oder der bereits aufgebrachten Schichten der organisch-elektronischen Vorrichtung hervorrufen.

Die Auswahl der Matrixmoleküle und der Emittermoleküle kann anmeldungsgemäß also insbesondere so erfolgen, dass bei Raumtemperatur keine Umorientierung der Emittermoleküle (beispielsweise auch durch Isomerisierungen der Liganden des phosphoreszenten Emitters) mehr erfolgen kann.

Die thermodynamische Kontrolle kann auch erfolgen indem sowohl eine langsame Aufwachsrate (wie vorstehend beschrieben) gewählt wird als auch indem die Emitterschicht einer Temperaturbehandlung unterworfen wird.

Gemäß einer weiteren Ausführungsform wird in Schritt A) der phosphoreszente Emitter mit anisotroper Molekülstruktur ausgewählt aus Iridium-Komplexen, Platin-Komplexen und Palladium-Komplexen bzw. aus Mischungen hiervon. Insbesondere die Iridium-Komplexe liefern sehr gute Quantenausbeuten, wenn sie als Emittermoleküle in organischen strahlungsemittierenden Vorrichtungen verwendet werden. Allerdings liefern auch Platin- und Palladium-Komplexe sehr gute Ergebnisse, da sich diese aufgrund der meist quadratisch planaren Koordination bei Vorliegen eines entsprechenden Matrixmaterials sehr leicht zu im Wesentlichen parallel zueinander und zur Substratoberfläche ausgerichteten Molekülanordnungen abscheiden lassen. Generell sind die phosphoreszenten Emitter aber nicht auf diese Metallkomplexe beschränkt; vielmehr sind grundsätzlich auch andere Metallkomplexe wie Lantanid-Komplexe (beispielsweise Europium-Komplexe) oder auch Gold-, Rhenium-, Rhodium-, Ruthenium-, Osmium- oder Zink-Komplexe geeignet.

Gemäß einer weiteren Ausführungsform werden als Iridium-Komplexe anmeldungsgemäß insbesondere Komplexe der folgenden Formel ausgewählt:

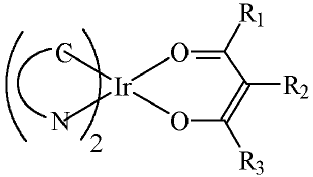

Hierbei ist CnN ein zumindest zweizähniger Ligand, der mit dem Metall-Atom einen metallacyclischen Ring bildet. Die Bezeichnung "CnN" steht weiters für einen Liganden, bei dem an das Iridium-Atom einerseits eine Koordination über ein Kohlenstoff-Atom und andererseits über ein Stickstoff-Atom erfolgt. Sowohl das Kohlenstoff-Atom als auch das Stickstoff-Atom liegen dabei üblicherweise in einem aromatischen Ringsystem vor. Im Fall des Kohlenstoff-Atoms ist dies zumeist ein homocyclischer aromatischer Ring. Unabhängig davon ist der über das Stickstoff-Atom an das Iridium-Atom koordinierte Ring üblicherweise ein heterocyclischer Ring, der neben dem Stickstoff-Atom kein weiteres oder nur ein weiteres Hetero-Atom (insbesondere ein weiteres Stickstoff-Atom oder ein Sauerstoff-Atom) enthält.

Die zwei CnN-Liganden können hierbei zusammen auch einen vierzähnigen Liganden bilden; ebenso ist eine Verbrückung des anderen Liganden (einem Acetylacetonat-Derivat) mit einem oder beiden der CnN-Liganden möglich. Im Acetylacetonat-Derivat stehen die Reste R1, R2 und R3 unabhängig voneinander für verzweigte, unverzweigte kondensierte und/oder ringförmige Alkylreste und/oder für Arylreste, es kann sich insbesondere um das Acetylacetonat selbst handeln. Sowohl die Arylreste als auch die Alkylreste können vollständig oder teilweise mit funktionellen Gruppen (beispielsweise EtherGruppen (etwa Metoxy-, Etoxy- oder Propoxy-Gruppen), EsterGruppen, Amid-Gruppen oder auch Carbonat-Gruppen) substituiert sein. Der Rest R2 kann auch Wasserstoff oder Fluor sein. Häufig werden die Reste R1 und R2 Methyl, Ethyl oder Propyl sein und gegebenenfalls auch Phenyl. R2 wird häufig Wasserstoff oder Fluor sein. Die genannten Ethyl-, Methyl-, Propyl- und Phenyl-Gruppen liegen dabei entweder unsubstituiert vor oder weisen einen oder mehrere Fluor-Substituenten auf. Die zuletzt genannten Verbindungen sind synthetisch einfach zu erhalten bzw. käuflich. Die Einführung von Fluor-Substituenten erleichtert im Regelfall die Verdampfbarkeit der Komplexe mit derartigen Liganden und führt zudem häufig zu einer Verschiebung der Emission zu kürzeren Wellenlängen.

Gemäß einer weiteren Ausführungsform bildet der Ligand CnN mit dem Iridium-Atom einen fünf-gliedrigen oder sechsgliedrigen metallacyclischen Ring. Insbesondere kann der Ligand CnN Phenylpyridin, Phenylimidazol, Phenyloxazol, Benzylpyridin, Benzylimidazol oder Benzyloxazol sein oder ein Ligand, der eine der genannten Verbindungen als Grundgerüst aufweist, bei dem also die entsprechende heterocyclische Grundstruktur enthalten ist, bei dem allerdings zusätzliche Substituenten, Verbrückungen oder annelierte Ringe vorhanden sind. Als Substituenten kommen insbesondere Fluoratome in Betracht, da durch Substitution mit einem oder mehreren Fluoratomen einer Verschiebung der Emissionswellenlänge in den blauen Spektralbereich (430 -500 nm) oder gar den violetten Spektralbereich (380-430 nm) erreichen lässt. Ferner können als Substituenten für verzweigte, unverzweigte kondensierte und/oder ringförmige Alkylreste und/oder Arylreste sowie funktionellen Gruppen (beispielsweise EtherGruppen (etwa Metoxy-, Etoxy- oder Propoxy-Gruppen), EsterGruppen, Amid-Gruppen oder auch Carbonat-Gruppen) enthalten sein.

Mit den Liganden gemäß dieser Ausführungsform lassen sich oft besonders große Übergangsdipolmomente erzielen.

Gemäß einer weiteren Ausführungsform weist der Ligand CnN mindestens drei zumindest zum Teil kondensierte aromatische Ringe auf. Häufig wird der Ligand sogar vier oder mehr zumindest zum Teil kondensierte aromatische Ringe aufweisen. "Zumindest zum Teil kondensiert" bedeutet hierbei, dass ein oder auch mehrere kondensierte Ringsysteme im Liganden CnN vorliegen können. Beispielsweise kann der Ligand durch drei miteinander kondensierte aromatische Ringe gebildet sein, an die eine Phenyl-Gruppe oder eine Benzyl-Gruppe angebunden ist. Liegt mehr als ein Ringsystem im Liganden vor, so kann der kondensierte aromatische Ring sowohl an den Stickstoffheterozyklus als auch an den homocyclischen Aromaten kondensiert sein oder auch an beide Ringe kondensiert sein.

Als Emittermaterialien kommen insbesondere folgende Verbindungen in Betracht, die ein Emissionsmaximum im blauen, grünen oder roten Spektralbereich aufweisen:
Ir(ppy)2(acac) = (Bis(2-phenylpyridin)(acetylacetonat) iridium(II)), Ir(mppy)2(acac) = (Bis[2-(p-tolyl)pyridin] acetylacetonat)iridium(III)), Bis[1-(9,9-dimethyl-9H-fluoren-2-yl)-isochinolin](acetylacetonat)iridium(III), Ir(mdq)2(acac) = (Bis(2-methyl-dibenzo[f,h]-chinoxalin) (acetylacetonat)iridium(III)), Iridium(III)-bis(dibenzo[f,h]-chinoxalin)(acetylacetonat), Ir(btp)2(acac) = (Bis(2-benzo[b] thiophen-2-yl-pyridin) (acetylacetonat)iridium(III)), Ir(piq)2(acac) = (Bis(1-phenylisochinolin) (acetylacetonat) iridium(III)), Ir(fliq)2(acac)-1 = (Bis[1-(9,9-dimethyl-9H-fluoren-2-yl)-isochinolin](acetylacetonat)iridium(III)), Hex-Ir(phq)2(acac) = Bis[2-(4-n-hexylphenyl)chinolin] (acetylacetonat)iridium(III), Ir(flq)2(acac)-2 = (Bis[3-(9,9-dimethyl-9H-fluoren-2-yl)-isochinolin] (acetylacetonat) iridium(III)), Bis[2-(9,9-dibutylfluorenyl)-1-isochinolin] (acetylacetonat)iridium(III), Bis[2-(9,9-dihexylfluorenyl)-1-pyridin](acetylacetonat) iridium(III), (fbi)2Ir(acac) = Bis(2-(9,9-diethyl-fluoren-2-yl)-1-phenyl-1H-benzo[d]imidazo-lato)(acetylacetonat)iridium(III), , Ir(2-phq)2(acac) = (Bis(2-phenylchinolin)(acetylacetonat)iridium(III)), Iridium (III)-bis(2-(2'-benzothienyl) pyridinato-N,C3')(acetylacetonat), Ir(BT)2(acac) = Bis(2-phenylbenzothiazolat) (acetylacetonat)iridium(III), (PQ)2Ir(dpm) = Bis(2-phenylchinolin) (2,2,6,6-tetramethylheptan-3,5-dionat) iridium(III), (Piq)2Ir(dpm) = Bis(phenylisochinolin)(2,2,6,6-tetramethylheptan-3,5-dionat)iridium(III) und Iridium(III) bis(4-phenylthieno[3,2-c]pyridinato-N,C2')acetylacetonat sowie Gemische der vorgenannten Stoffe. Für Emittermaterialien, die im blauen Wellenlängenbereich emittieren kommen beispielsweise Carbenkomplexe des Iridiums in Betracht. Die Bezeichnung "CnN" steht dann also für einen Liganden, bei dem an das Iridium-Atom eine Koordination über ein Carben-Kohlenstoff-Atom und ein Stickstoff-Atom erfolgt.

Gemäß einer weiteren Ausführungsform kann neben dem phosphoreszenten Metallkomplex auch das Matixmaterial eine anisotrope Molekülstruktur aufweisen. Mittels derartiger Matrixmaterialien kann eine anisotrope Ausrichtung der phosphoreszenten Metallkomplexe zusätzlich unterstützt werden.

Entsprechend zu den anisotropen phosphoreszenten Metallkomplexen gilt auch für das Matrixmaterial mit anisotroper Molekülstruktur, dass hier insbesondere keine im Wesentlichen symmetrisch substituierten Verknüpfungspunkte vorliegen dürfen, wie etwa ein in eins, drei und fünf Position (symmetrisch) substitutierter aromatischer Sechsring oder ein tertiäres Amin mit jeweils drei gleichen Substituenten.

Insbesondere wird unter einem Matrixmaterial mit anisotroper Molekülstruktur ein Material verstanden, bei dem ausgehend von einer zentralen Verzweigungsstelle, insbesondere einem zentralen Atom oder einem zentralen Ring, keine drei, vier oder mehr Substituenten mit gleicher oder im Wesentlichen gleicher Struktur vorliegen (wobei nur Substituenten beachtet werden, die nicht Wasserstoff sind). Eine gleiche Struktur bedeutet dabei, dass die Substituenten identisch sind; eine im Wesentlichen gleiche Struktur bedeutet ferner, dass sich die mindestens drei Substituenten hinsichtlich des auf sie entfallenden Molekulargewichts zwar unterscheiden, dass bei aber bei keinem der Substituenten der Verzweigungsstelle ein Molekulargewicht vorliegt, das um zumindest 50 % unter einem der anderen Substituenten liegt (wobei nur Substituenten beachtet werden, die nicht Wasserstoff sind). Dementsprechend sind Moleküle mit anisotroper Molekülstruktur keine hochsymmetrischen Moleküle mit mehr als zwei gleichen Substituenten oder sie weisen bei Verzweigungsstellen mit drei oder mehr Substituenten (z. B. Verzweigungsstellen wie tertiären Amin-Stickstoffatomen oder zumindest dreifach substituierten Benzol-Ringen) sehr unterschiedliche Substituenten auf.

Die vorstehend definierte Verzweigungsstelle ist insbesondere die Verzweigungsstelle, die dem Molekülschwerpunkt am nächsten liegt. Der Molekülschwerpunkt ist zwar aufgrund möglicher Rotationen von Teilbereichen des Moleküls aufwändig zu bestimmen; allerdings ist es für den Fachmann bei den meisten Molekülen ohne Berechnung vollkommen klar, welche Verzweigungsstelle in einem Molekül dem Schwerpunkt am nächsten liegt, da für die Bestimmung näherungsweise auch der Schwerpunkt ausreicht, der sich ergeben würde, wenn für alle Atome angenommen werden würde, dass sie tatsächlich nur zweidimensional in der Papierebene angeordnet sind.

Gemäß einer weiteren Ausführungsform wird das Matrixmaterial in Schritt A) aus Verbindungen des Typs A-K-B ausgewählt.

Hierbei steht das Strukturelement K für eine Struktur Ar1-X-Ar2, die insbesondere kettenartig ist. Hierbei stehen Ar1 und Ar2 für gleiche oder verschiedene aromatische Ringe und X für eine Einfachbindung, eine weitere aromatische Gruppe oder für eine Verknüpfung (von Ar1 und Ar2) mittels eines annelierten (bzw. kondensierten) Rings, also eines Rings, mit dem beide Reste Ar1 und Ar2 miteinander kondensiert sind.

Ferner sind auch die Strukturelemente A und B gleich oder verschieden und umfassen jeweils zumindest einen aromatischen Ring, insbesondere einen aromatischen Ring, der an das Strukturelement K direkt oder mittelbar (d.h. verknüpft über weitere Atome oder Gruppen) gebunden ist.

Die Gruppen Ar1, Ar2 und X (falls es eine aromatische Gruppe darstellt) können unsubstituierte oder beliebig substituierte aromatische Verbindungen sein, insbesondere sind die Substituenten aber ausgewählt aus sterisch wenig anspruchsvollen Gruppen. Im Regelfall werden die aromatischen Ringe Ar1, Ar2 und X daher keine Substituenten aufweisen, deren Kohlenstoff-Atome zwingend nicht in der Ebene zu liegen kommen, die durch den aromatischen Ring aufgespannt ist, und meist auch keine Substituenten, die zumindest teilweise (räumlich und/oder zeitlich) nicht in der durch den Aromaten aufgespannten Ebene liegen. Entsprechendes gilt auch für Substituenten des Strukturelements X, sofern es sich um eine nicht aromatische Verbrückung der aromatischen Ring Ar1 und Ar2 handelt. Hier kann eine etwaige Alkylen-Verknüpfung (wie sie beispielsweise in einer durch die Struktur Ar1-X-Ar2 beschriebenen Fluoren-Gruppe vorliegt) ebenfalls beliebig substituiert sein. Allerdings wird es sich aus sterischen Gründen bei den Substituenten häufig nur um sterisch wenig anspruchsvolle Substituenten wie Methyl-, Ethyl- oder Propyl-Gruppen oder um cyclische bzw. spirocyclische Alkylengruppen handeln oder um Gruppen, die sterisch einen Platzbedarf haben, der dem der genannten Gruppen entspricht oder geringer ist (beispielsweise Metoxy-Gruppen). Im Ausnahmefall kann, insbesondere bei entsprechend ausladenden Substituenten der Gruppen A und B auch eine Phenyl-Gruppe an eine derartige Alkylen- (beispielsweise Methylen-) Gruppe gebunden sein.

Die Struktur Ar1-X-Ar2 ist insbesondere kettenartig ausgebildet. Hierbei heißt kettenartig, dass die zwei bzw. drei Ringe dieses Strukturelements in Bezug auf die Strukturelemente A und B so aneinander gebunden sind, dass die Gruppen A und X (bzw. A und Ar2 für den Fall, dass X eine Bindung oder einen an Ar1 und Ar2 annelierten Ring darstellt) in Para-Position zueinander angeordnet sind. Dieselbe Strukturbeziehung gilt ebenfalls für die Anordnung der Gruppen B und X bzw. B und Ar1. Zusätzlich können allerdings weitere Verknüpfungen insbesondere zwischen den Ringen Ar1 und Ar2 vorliegen, wie sie beispielsweise ohnehin im Fall eines an Ar1 und Ar2 annelierten Rings X vorhanden sind.

Durch Auswahl eines Matrixmaterials mit einem Strukturelement K, das, wie aus den vorstehenden Ausführungen deutlich wird, eher planar als kugelförmig ausgebildet ist, kann ein Material zur Verfügung gestellt werden, was eine ausgeprägte Anisotropie zeigt und sich daher besonders gut für das erfindungsgemäße Verfahren eignet. Wesentlich hierbei ist, dass die Verknüpfung der Strukturelemente A, K und B gewissermaßen kettenförmig ist, wodurch erreicht wird, dass die Moleküle in Bezug auf die durch die Gruppen A, K und B verlaufende Längsachse deutlich länger ist als die Ausdehnung des Moleküls in den Richtungen orthogonal zu dieser Achse, insbesondere so weit der Bereich des Strukturelements K betroffen ist.

Gemäß einer weiteren Ausführungsform weist daher das Strukturelement K keine spirocyclische Gruppe mit mehr als fünf Kohlenstoffatomen auf, insbesondere keine derartige Gruppe, bei der eine Alkylen-Gruppe, die die Ringe Ar1 und Ar2 miteinander verbindet, einen spirocyclischen Ring als Substituenten trägt, der direkt an die Alkylen-Gruppe gebunden ist. Auch hierdurch kann unterbunden werden, dass das mittlere Strukturelement K des Matrixmaterials zu ausladend wird.

Gemäß einer weiteren Ausführungsform stehen die Gruppen Ar1 und Ar2 des Strukturelements K jeweils für einen Stickstoffhaltigen Heterocyclus und können beispielsweise ein Biphenyl-, ein Phenanthrolin-, ein Pyridin-, ein Bipyridin- und/oder ein Pyrimidin-Derivat umfassen. Ferner kann unabhängig hiervon sowohl das Strukturelement A als auch das Strukturelement B des Matrixmaterials A-K-B eine aromatisch substituierte Amingruppe umfassen, insbesondere eine aromatisch substituierte Amingruppe, die direkt an das Strukturelement K gebunden ist. Insbesondere kann das Matrixmaterial in diesem Fall ein Benzidin-Derivat umfassen.

Derartige Matrixmaterialien weisen also ein eher flächiges zentrales Segment in Form der Benzidin-Gruppe bzw. der Phenanthrolin-Gruppe auf, sodass eine anisotrope Molekülstruktur erreicht werden kann.

Gemäß einer weiteren Ausführungsform können auch die Strukturelemente A und B des Matrixmaterials so ausgebildet werden, dass eine besonders anisotrope Molekülstruktur resultiert. Hierzu können gewissermaßen an den "Enden" eines eher langgestreckten Moleküle sterisch anspruchsvolle Substituenten vorgesehen werden. Die Strukturelemente A und B können daher beispielsweise einen substituierten Aromaten umfassen, der eine tertiäre Alkyl-Gruppe trägt (insbesondere in para-Stellung). Enthalten die Strukturelemente A und B jeweils ein Stickstoff-Atom, das direkt an Strukturelement K gebunden ist, so kann nur einer der zwei terminalen Substituenten des Stickstoff-Atoms oder auch beide terminalen Substituenten eine derartige substituierte aromatische Gruppe tragen. Statt einer mit einer tertiären Alkyl-Gruppe substituierten aromatischen Gruppe kann auch eine polycyclische Aryl-Gruppe, in der zumindest zwei aromatische Ringe aneinander kondensiert sind, als sterisch anspruchsvolle Gruppe vorliegen. Beispielsweise sind hierbei Naphtyl-Gruppen zu nennen.

Gemäß einer weiteren Ausführungsform kann das Matrixmaterial lochtransportierende und/oder elektronentransportierende Eigenschaften aufweisen. Emittiert der phosphoreszente Emitter im violetten, blauen oder grünen Spektralbereich (also insbesondere bei einer Wellenlänge < 570 nm), so wird häufig ein elektronentransportierendes Matrixmaterial gewählt, weil dies im Regelfall aufgrund der Lage der Triplett-Niveaus des Matrixmaterials und des Emitter-Materials günstiger ist.

Gemäß einer weiteren Ausführungsform kann das Matrixmaterial aus einer oder mehreren der nachfolgenden Verbindungen ausgewählt sein oder zumindest eine der genannten Verbindungen umfassen:
Als Elektronentransportmaterialien seien beispielsweise PBD (2-(4-Biphenylyl)-5-(4-tert-butylphenyl)-1,3,4-oxadiazol), BCP (2,9-Dimethyl-4,7-diphenyl-1,10-phenanthrolin), BPhen (4,7-Diphenyl-1,10-phenanthrolin), TAZ (3-(4-Biphenylyl)-4-phenyl-5-tert-butylphenyl-1,2,4-triazol), Bpy-OXD (1,3-Bis[2-(2,2'-bipyrid-6-yl)-1,3,4-oxadiazol-5-yl]benzol), BP-OXD-Bpy (6,6'-Bis[5-(biphenyl-4-yl)-1,3,4-oxadiazol-2-yl]-2,2'-bipyridyl), PADN (2-phenyl-9,10-di(naphth-2-yl)-anthracene), Bpy-FOXD (2,7-Bis[2-(2,2'-bipyrid-6-yl)-1,3,4-oxadiazol-5-yl]-9,9-dimethylfluoren), OXD-7 (1,3-Bis[2-(4-tert-butylphenyl)-1,3,4-oxadiazol-5-yl]benzol), HNBphen (2-(naphth-2-yl)-4,7-diphenyl-1,10-phenanthrolin), NBphen (2,9-Bis(naphth-2-yl)-4,7-diphenyl-1,10-phenanthrolin), und 2-NPIP (1-methyl-2-(4-(naphth-2-yl)phenyl)-1H-imidazo[4,5-f][1,10]phenanthrolin) sowie Gemische der vorgenannten Stoffe genannt.

Als Lochtransportmaterialien seien zum Beispiel NPB (N,N'-Bis(naphth-1-yl)-N,N'-bis(phenyl)-benzidin, β-NPB (N,N'-Bis(naphth-2-yl)-N,N'-bis(phenyl)-benzidin), TPD (N,N'-Bis(3-methylphenyl)-N,N'-bis(phenyl)-benzidin), N,N'-Bis(naphth-1-yl)-N,N'-bis(phenyl)-2,2-dimethylbenzidin, DMFL-TPD (N,N'-Bis(3-methylphenyl)-N,N'-bis (phenyl)-9,9-dimethylfluor en, DMFL-NPB (N,N'-Bis(naphth-1-yl)-N,N'-bis(phenyl)-9,9-dimethylfluoren), DPFL-TPD (N,N'-Bis(3-methylphenyl)-N,N'-bis(phenyl)-9,9-diphenylfluoren), DPFL-NPB (N,N'-Bis(naphth-1-yl)-N,N'-bis(phenyl)-9,9-diphenylfluoren), TAPC (Di-[4-(N,N-ditolyl-amino)-phenyl]cyclohexan), PAPB (N, N'-bis(phenanthren-9-yl)-N,N'-bis(phenyl)-benzidin), TNB (N, N,N',N'-tetra-naphth-2-yl-benzidin), TiOPC (Titanoxide phthalocyanin), CuPC (Kupfer-Phthalocyanin), F4-TCNQ (2,3,5,6-Tetrafluor-7,7,8,8,-tetracyano-chinodimethan), PPDN (Pyrazino[2,3-f][1,10]phenanthrolin-2,3-dicarbonitril), MeO-TPD (N, N,N' ,N' -Tetrakis(4-methoxyphenyl)benzidin), β - NPP (N, N'-di(naphth-2-yl)-N,N'-diphenylbenzol-1,4-diamin), NTNPB (N,N'-di-phenyl-N,N'-di-[4-(N, N-di-tolyl-amino)phenyl] benzidin) und NPNPB (N,N'-di-phenyl-N,N'-di-[4-(N, N-diphenyl-amino)phenyl]benzidin), 1,4-bis(2-phenylpyrimidin-5-yl)benzen (BPPyP), 1,4-bis(2-methylpyrimidin-5-yl)benzen (BMPyP), 1,4-di(1,10-phenanthrolin-3-yl)benzen (BBCP), 2,5-di(pyridin-4-yl)pyrimidin (DPyPy), 1,4-bis(2-(pyridin-4-yl)pyrimidin-5-yl)benzen (BPyPyP), 2,2',6,6'-tetraphenyl-4,4'-bipyridin (GBPy), 1,4-di(benzo[h]chinolin-3-yl)benzol (PBAPA), 2,3,5,6-tetraphenyl-4,4'-bipyridin (TPPyPy), 1,4-bis(2,3,5,6-tetraphenylpyridin-4-yl)benzen (BTPPyP), 1,4-bis(2,6-tetrapyridinylpyridin-4-yl)benzen (BDPyPyP) oder Gemische der vorgenannten Stoffe genannt.

Es wird ferner eine strahlungsemittierende organischelektronische Vorrichtung beschrieben, die mit dem vorstehend beschriebenen Verfahren erhältlich ist. Die Vorrichtung zeichnet sich insbesondere dadurch aus, dass gegenüber dem Stand der Technik erhöhte Quanteneffizienzen zu verzeichnen sind, da durch die Ausrichtung der Emitter-Moleküle im Matrixmaterial der Verlustkanal der Energieauskopplung durch Plasmonen versperrt werden kann.

Weiterhin wird beschrieben, dass zwischen der Emitterschicht der strahlungsemittierenden Vorrichtung und einer aus Metall gebildeten Elektrode der Vorrichtung, insbesondere der Kathode, weitere organische Schichten angeordnet sind. Handelt es sich bei der Metall-Elektrode um eine Kathode, so ist zumindest eine der folgenden Schichten zwischen der Emitterschicht und der Kathode angeordnet:
Elektroneninjektionsschicht, Elektronentransportschicht, Lochblockierschicht; ist die Metall-Elektrode eine Anode, so ist zumindest eine der folgenden Schichten zwischen Anode und Emitterschicht angeordnet: Lochinjektionsschicht, Lochtransportschicht, Elektronenblockierschicht. Der Abstand zwischen Metallelektrode und Emitterschicht kann dann insbesondere 50 bis 200 nm betragen, beispielsweise 80 bis 120 nm. Tendenziell kann ein Abstand von zumindest 50 nm bewirken, dass die Auskopplung über Plasmonen zusätzlich vermindert wird; wird die Schichtdicke der zwischen Emitterschicht und Metall-Elektrode angeordneten Schichten zu dick, so wird der hierdurch erzielte Effekt allerdings dadurch teilweise kompensiert, dass die organischen Schichten des Schichtstapels zu Energieabsorptionen und damit bei zu großer Dicke zu einer verminderten Effizienz führen.

Weitere Vorteile und vorteilhafte Ausführungsform und Weiterbildungen der Erfindung ergeben sich aus den im Folgenden in Verbindung mit den Figuren und dem Beispiel beschriebenen Ausführungsformen. Es zeigt:
Figur 1 und 2 jeweils eine schematische Darstellung eines strahlungsemittierenden Bauelements,
Figur 3A und B jeweils eine Messung der Strahlungsintensität abhängig von der Polarisation des zur Anregung benützten Laserlichts und vom Emissionswinkel.

Gleiche, gleichartige und gleich wirkende Elemente sind in den Figuren mit gleichen Bezugszeichen versehen.

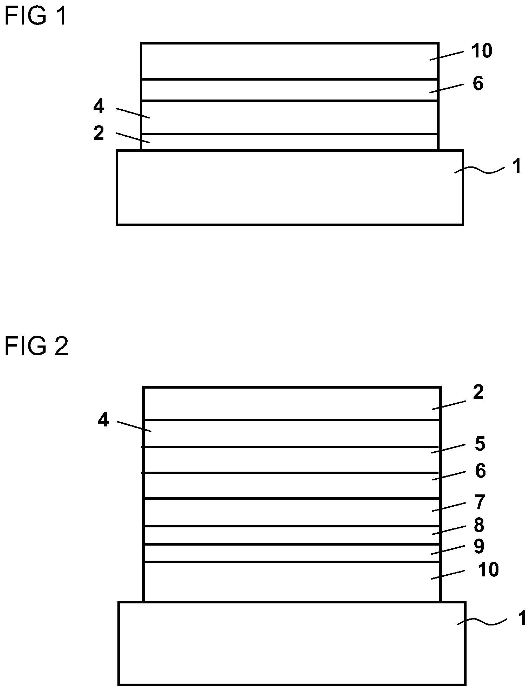

Die Figur 1 zeigt den schematisierten Aufbau eines organischen strahlungsemittierenden Bauteils.

Von unten nach oben ist in Figur 1 folgender Schichtaufbau realisiert: Zuunterst befindet sich das Substrat 1. Beispielsweise wird als strahlungsdurchlässiges Substrat ein Glassubstrat, zum Beispiel aus Borofloat-Glas, oder ein Kunststoff-(Folien)Substrat, z.B. aus PMMA (Polymethylmethacrylat), eingesetzt.

Auf dem Substrat 1 befindet sich eine Anodenschicht 2, die beispielsweise aus einem transparenten leitenden Oxid bestehen kann beziehungsweise dieses umfassen kann. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO2 oder In2O3 gehören auch ternäre Metallsauerstoffverbindungen, wie beispielsweise Zn2SnO4, CdSnO3, ZnSnO3, MgIn2O4, GaInO3, Zn2In2O5 oder In4Sn3O12 oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein. Ferner kann beispielsweise auch eine transparente Anodenschicht 2 vorliegen, die aus einer dünnen Metallschicht (etwa aus Silber) oder aus einer Legierung (etwa AgMg) besteht beziehungsweise, die ein derartiges Metall oder eine derartige Legierung enthält. Auf der Anodenschicht 2 ist eine Lochtransport-Schicht 4 angeordnet, die aus einem Material besteht beziehungsweise dieses enthält, das beispielsweise ausgewählt sein kann aus tertiären Aminen, Carbazolderivaten, Polyanilin oder Polyethylendioxythiophen. Beispielhaft sei NPB, TAPC oder andere der vorstehenden anisotropen Lochtransportmaterialien genannt. Allerdings sind für die Lochtransport-Schicht 4 auch nicht anisotrope Materialien geeignet. Auf die Lochtransportschicht folgt die aktive Schicht- im Fall einer OLED zum Beispiel eine organische Emitterschicht 6. Diese Emitterschicht umfasst das anisotrope Matrixmaterial und den anisotropen phosphoreszenten Emitter bzw. besteht hieraus. Auf der Emitterschicht ist schließlich eine Kathode 10, insbesondere eine Metallkathode, gegebenenfalls aber auch eine Kathode, die ebenfalls aus einem transparenten leitenden Oxid gefertigt ist (was zu einem Top/Bottom-Emitter führt) angeordnet. Beispielsweise kann die Kathode aus Silber, Aluminium, Cadmium, Barium, Indium, Magnesium, Kalzium, Lithium oder Gold bestehen oder eines oder mehrere dieser Metalle umfassen. Die Kathode kann dabei auch mehrschichtig ausgebildet sein.

Bei Anlegen einer Spannung zwischen Anode und Kathode fließt Strom durch das Bauteil und in der organisch aktiven Schicht werden Photonen freigesetzt, die in Form von Licht über die transparente Anode und das Substrat beziehungsweise im Fall eines Top/Bottom-Emitters auch über die transparente Kathode das Bauteil verlassen. In einer Ausführungsform emittiert die OLED weißes Licht; in diesem Fall enthält die Emitterschicht entweder mehrere verschiedenfarbig (zum Beispiel blau und gelb oder blau, grün und rot) emittierende Emittermaterialien; alternativ kann die Emitterschicht auch aus mehreren Teilschichten aufgebaut sein, in denen jeweils eine der genannten Farben emittiert wird, wobei durch Mischung der verschiedenen Farben die Emission von Licht mit weißem Farbeindruck resultiert. Alternativ kann im Strahlengang der durch diese Schichten erzeugten Primäremission auch ein Konvertermaterial angeordnet sein, das die Primärstrahlung zumindest teilweise absorbiert und eine Sekundärstrahlung anderer Wellenlänge emittiert, so dass sich aus einer (noch nicht weißen) Primärstrahlung durch die Kombination von primärer und sekundärer Strahlung ein weißer Farbeindruck ergibt.

Das Bauelement 1 ist vorzugsweise zur Beleuchtung, insbesondere zur Allgemeinbeleuchtung, zweckmäßigerweise zur Erzeugung sichtbarer Strahlung ausgebildet, ausgebildet. Das Bauelement kann beispielsweise zur Innenraumbeleuchtung, zur Außenraumbeleuchtung oder in einer Signalleuchte eingesetzt werden.

Figur 2 zeigt eine OLED, die als Topemitter ausgebildet ist; ist die Kathode 10 transparent, so handelt es sich um einen Top/Bottom-Emitter.

Hier ist auf einem Substrat 1 (zum Beispiel einem GlasSubstrat) eine Kathode 10 angeordnet (die zum Beispiel aus einem Metall gebildet ist oder - insbesondere wenn eine transparente Elektrode erwünscht ist - aus einem TCO gefertigt ist). Auf der Kathode ist eine Elektroneninjektionsschicht 9 angeordnet, auf dieser befindet sich eine Elektronentransportschicht 8. Auf der Elektronentransportschicht 8 befindet sich eine lochblockierende Schicht 7 auf der dann die organische Emitterschicht 6 angeordnet ist. Diese Emitterschicht kann wie zu Figur 1 beschrieben ausgebildet sein.

Auf der Emitterschicht befindet sich eine Lochtransportschicht 5, die beispielsweise TPBi (2,2',2''-(1,3,5-Benz-triyl)-tris(1-phenyl-1-H-benzimidazol)) oder auch eines der vorstehenden anisotropen Elektronentransportmateialien umfassen kann. Allerdings sind für die Lochtransportschicht 5 auch nicht anisotrope Materialien geeignet. Auf der Lochtransportschicht befindet sich wiederum eine Lochinjektionsschicht 4. Über der Lochinjektionsschicht 4 befindet sich Anode, die zum Beispiel aus einem TCO gebildet ist.

Die organischen Schichten können mittels Aufdampfens aufgebracht werden. Hierzu wird das zu beschichtende Substrat mit Elektrode beziehungsweise Elektrode und dielektrischer Schicht in einen Rezipienten eingebracht, der die verschiedenen organischen Materialien in verschiedenen Quellen enthält. Zur Herstellung der einzelnen funktionellen Schichten werden dann aus den jeweiligen Quellen die organischen Substanzen verdampft und auf der beschichteten Oberfläche abgeschieden. Ferner werden mehrere Quellen für die Zuführung von ein oder mehreren verschiedenen Matrixmaterialien vorgesehen. Beispielsweise wird zur Ausbildung der Emitterschicht eine Quelle mit anisotropem Matrixmaterial und eine Quelle mit dem phosphoreszenten anisotropen Emitter verwendet. Entsprechend kann die Abscheidung der weiteren organischen Schichten erfolgen. Grundsätzlich ist auch noch eine gemischte Abscheidung möglich, bei der die ersten organischen Schichten mittels Spincoating aufgebracht werden und spätestens ab der Emitterschicht die weiteren organischen Schichten mittels Verdampfen aufgebracht werden möglich.

Auf die Darstellung einer Verkapselung für die organischen Schichten wurde aus Übersichtlichkeitsgründen verzichtet. Ebenso wurde aus Übersichtlichkeitsgründen verzichtet, eine gegebenenfalls enthaltene Strahlungsauskopplungsschicht darzustellen. Eine Verkapselung kapselt die organische Schicht gegenüber schädlichen äußeren Einflüssen, wie Feuchtigkeit oder Sauerstoff, ab. Die Verkapselung kann z.B. als Dachkonstruktion ausgebildet sein. Auch auf eine explizite Darstellung der elektrischen Kontaktierung des Bauelements wurde verzichtet. So kann z.B. eine Ansteuerschaltung des Bauelements auf dem Substrat - ebenfalls innerhalb der Verkapselung - angeordnet sein.

Zur Messung der Orientierung der Emittermoleküle (bzw. der für die Emission relevanten Dipole) wurde folgende Vorrichtung nach einem nicht beanspruchten Verfahren hergestellt. Auf einem 0,7 mm dicken Glassubstrat wurde eine 103 nm dicke ITO-Schicht aufgesputtert. Die nachfolgenden organischen Schichten wurden - wie vorstehend beschrieben - mittels Verdampfung aufgebracht. Dies sind eine 31 nm dicke Lochtransportschicht, eine 10 nm dicke Elektronenblockierschicht, eine 10 nm dicke Emitterschicht aus 92 % α-NPD und 8 Gew.-% bis Iridium(III)-bis(dibenzo[f,h]-chinoxalin)(acetylacetonat) abgeschieden. Zur Einstellung thermodynamischer Bedingungen wurde die Aufwachsrate bei 0,05 nm/s und einem Druck von 10-7 mbar gewählt. Nach Abscheiden der Emitterschicht wurden eine 10 nm dicke Lochblockierschicht und eine 65 nm dicke Elektronentransportschicht abgeschieden. Für die Messung der Emitterorientierung wurde ein derart erzeugter OLED-Stack ohne Kathode verwendet; für die Messung der Effizienz wurde eine 200 nm dicke Kathode aus Silber verwendet.

Zur Messung der Orientierung der Übergangs-Dipol-Momente wurde mit einem Winkel von 45° auf die dem Substrat abgewandte Seite des OLED-Stacks kontinuierlich Strahlung mit einer Wellenlänge von 375 nm (mittels eines cw-Lasers) eingestrahlt. Auf der Substratseite wurde dann die emittierte Strahlung winkelabhängig detektiert. Dabei wurde zum einen P-polarisiertes Licht (TM-polarisiert), zum anderen s-polarisiertes Licht (TE-polarisiert) gemessen. Der cw-Laser weist dabei im Wesentlichen linear polarisiertes Licht auf. Die winkelabhängigen Photolumineszenz-Spektren werden mittels eines kalibrierten faseroptischen Spektrometers und einem Polarisator gemessen, um zwischen TE- und TM-polarisierter Emission zu unterscheiden. Die gemessenen Intensitäten werden auf die Messwerte bei niedrigen Winkeln normalisiert, da die Emission in diesem Bereich ausschließlich von parallel angeordneten Dipolen herrührt. Im Übrigen wurde beobachtet, dass die Emissionsverteilung unabhängig von der Einstrahlungsrichtung und der Polarisation der zur Anregung benutzten Laserstrahlung ist.

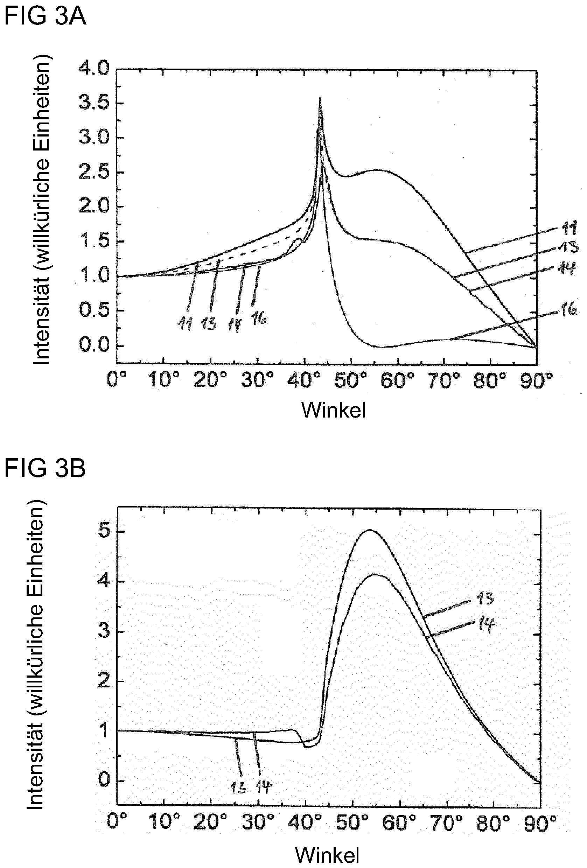

Figur 3A zeigt die detektierte relative Intensität abhängig vom Emissionswinkel für p-polarisiertes Licht der Wellenlänge 610 nm. In Figur 3A sind dabei die simulierten relativen Intensitäten für eine Emitterschicht mit vollständig isotroper Ausrichtung der Emittermoleküle bzw. Dipole (Bezugszeichen 11) für eine vollständig horizontal ausgerichtete Orientierung der Dipole der Emittermoleküle (Bezugszeichen 16) und für eine Emitterschicht, in der 60 % der Emittermoleküle willkürlich verteilt sind und 40 % horizontal ausgerichtete Dipole vorliegen (gestrichelte Linie, Bezugszeichen 13) zu erkennen. Die tatsächlich gemessene Intensitätsverteilung zeigt die Linie mit dem Bezugszeichen 14; hierbei ist zu erkennen, dass insbesondere bei Winkeln größer 45° die Intensitätsverteilung deckungsgleich ist mit Linie 13, also der simulierten Intensitätsverteilung.

Figur 3B zeigt die entsprechenden Ergebnisse, wenn statt P-polarisierter Strahlung s-polarisierte Strahlung einer Wellenlänge von 610 nm gemessen wird. Auch hier ergibt sich eine gute Übereinstimmung des simulierten Graphen 13 und der tatsächlich gemessenen Kurve 14.

In beiden Grafiken wurden die simulierten Spektren mittels der Vorgaben gemäß Krummacher et al., Organic Electronics 10 (2009) 478-485 beziehungsweise Danz et al. J. Opt. Soc. Am. B/Vol. 19, No. 3, 412-419 sowie der in diesen beiden Schriften angegebenen Literaturstellen berechnet.

Die beste Übereinstimmung zwischen simuliertem und tatsächlich gemessenem Wert ergibt sich für eine Verteilung von 69,3 % willkürlich verteilten Dipolen und 30,7 % horizontal ausgerichteten Dipolen, woraus sich aufgrund der Tatsache, dass statistisch gesehen bei einer isotropen Ausrichtung 2/3 der Dipole in der durch die OLED-Schichten gebildeten Ebene liegen und 1/3 orthogonal dazu ausgerichtet ist berechnen lässt, dass (den Anteil der willkürlich ausgerichteten Dipole miteingerechnet) 76,9 % horizontale Orientierung der Übergangs-Dipol-Momente in der OLED gemäß dem vorstehend beschriebenen Beispiel vorliegen.

Verallgemeinert kann also festgestellt werden, dass mit dem zur Messung der Orientierung der Emittermoleküle beschriebenen Verfahren generell eine horizontale Orientierung der Übergangs-Dipol-Momente erreicht werden kann, die üblicherweise über 75 % liegt und bei entsprechend ausgewählten anisotropen Matrixmaterialien und anisotropen phosphoreszenten Emittern sogar einen Anteil von mehr als 80 % besitzen kann. Vorstellbar ist, dass bei besonders gut aufeinander abgestimmten Emitter-Matrixmaterial-Systemen auch Werte von 90 % horizontaler Orientierung erreichbar sind.

Für die genannte Vorrichtung wurde auch der Anteil der jeweiligen Verlustkanäle ermittelt. Danach beträgt der Verlust durch Wellenleitereffekte 10,6 %, der Verlust durch Plasmonen 28,2 % und der Verlust durch Absorption 3 %. Die Emission zum Substrat beträgt 33,6 % und die zur Luft 24,6 %. Damit kann die Effizienz gegenüber dem isotropen Fall um 13,9 % verbessert werden (dort beträgt der Verlust durch Wellenleiteffekte 9,6 %, der Verlust durch Plasmonen 36,6 % und der Verlust durch Absorption 2,7 %). Bei einer 100 % horizontalen Orientierung der Dipole wäre sogar nur noch von 10 % Verlust durch die Plasmonen auszugehen, wodurch eine Effizienzsteigerung um 44 % gegenüber der isotropen Ausrichtung zu verzeichnen wäre.

## Patentansprüche

1. Verfahren zur Herstellung einer strahlungsemittierenden organisch elektronischen Vorrichtung mit einer ersten und einer zweiten Elektrodenschicht und einer Emitterschicht mit folgenden Schritten:
A) Bereitstellen eines phosphoreszenten Emitters mit anisotroper Molekülstruktur und eines Matrixmaterials,
B) Aufbringen der ersten Elektrodenschicht auf ein Substrat,
C) Aufbringen der Emitterschicht unter thermodynamischer Kontrolle, wobei der phosphoreszente Emitter und das Matrixmaterial im Vakuum verdampft werden und auf der ersten Elektrodenschicht abgeschieden werden, so dass eine anisotrope Ausrichtung der Moleküle des phosphoreszenten Emitters erfolgt und wobei die thermodynamische Kontrolle erfolgt, indem nach und/oder während dem Abscheidungsschritt und vor Abscheiden einer weiteren Schicht die abgeschiedene Emitterschicht auf eine gegenüber Raumtemperatur erhöhte Temperatur zwischen 30 °C und 100 °C gebracht wird oder auf einer derartigen Temperatur gehalten wird
D) Aufbringen der zweiten Elektrodenschicht auf der Emitterschicht.

2. Verfahren nach dem vorhergehenden Anspruch, wobei in Schritt A) der phosphoreszente Emitter mit anisotroper Molekülstruktur ausgewählt ist aus Iridium-Komplexen, Platin-Komplexen und Palladium-Komplexen und Mischungen hiervon.

3. Verfahren nach dem vorhergehenden Anspruch, wobei ein Iridium-Komplex der folgenden Formel ausgewählt wird: 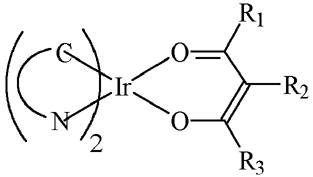 wobei CnN ein zumindest zweizähniger Ligand ist, der mit dem Ir-Atom einen metallacyclischen Ring bildet und wobei R1, R2 und R3 - unabhängig voneinander - unverzweigte, verzweigte Alkylreste, kondensierte und/oder ringförmige Alkylreste und/oder Arylreste sind, die jeweils vollständig oder teilweise substituiert sein können und wobei R2 auch H oder F sein kann.

4. Verfahren nach dem vorhergehenden Anspruch, wobei der Ligand CnN einen 5-gliedrigen oder 6-gliedrigen metallacyclischen Ring mit dem Ir-Atom bildet.

5. Verfahren nach dem vorhergehenden Anspruch, wobei der Ligand CnN Phenylpyridin, Phenylimidazol, Phenyloxazol, Benzylpyridin, Benzylimidazol, Benzyloxazol oder ein Ligand, der eine der genannten Verbindungen als Grundgerüst aufweist ist.

6. Verfahren nach einem der drei vorhergehenden Ansprüche, wobei der Ligand CnN mindestens 3 zumindest zum Teil kondensierte aromatische Ringe aufweist.

7. Verfahren nach einem der vorhergehenden Ansprüche, wobei das bereitgestellte Matrixmaterial eine anisotrope Molekülstruktur aufweist.

8. Verfahren nach dem vorhergehenden Anspruch, wobei ein Matrixmaterial des Typs A-K-B ausgewählt wird,
wobei Strukturelement K für eine Struktur Ar1-X-Ar2 steht, wobei Ar1 und Ar2 gleiche oder verschiedene aromatische Ringe sind und X für eine Einfachbindung, eine weitere aromatische Gruppe oder für eine Verknüpfung von Ar1 und Ar2 mittels eines annelierten Rings steht
wobei die Strukturelemente A und B gleich oder verschieden sind und jeweils zumindest einen aromatischen Ring umfassen.

9. Verfahren nach einem der beiden vorhergehenden Ansprüche, wobei die Gruppen Ar1 und Ar2 des Strukturelements K jeweils für einen Stickstoffheterocyclus stehen und/oder die Strukturelemente A und B jeweils eine aromatisch substituierte Amin-Gruppe umfassen.

10. Verfahren nach dem vorhergehenden Anspruch, wobei das Matrixmaterial ein Benzidin-Derivat oder ein Phenanthrolin-Derivat umfasst.

11. Verfahren nach einem der vier vorhergehenden Ansprüche, wobei die Strukturelemente A und B jeweils mindestens einen mit einer tertiären Alkylgruppe substituierten Aromaten und/oder jeweils mindestens eine kondensierte polycyclische Arylgruppe umfassen.

12. Verfahren nach einem der fünf vorhergehenden Ansprüche, wobei das Matrixmaterial lochtransportierende und/oder elektronentransportierende Eigenschaften hat.

## Claims

1. Method for producing a radiation-emitting organic electronic device having a first and a second electrode layer and an emitter layer, comprising the following steps:
A) providing a phosphorescent emitter having an anisotropic molecular structure and a matrix material,
B) applying the first electrode layer to a substrate,
C) applying the emitter layer under thermodynamic control, wherein the phosphorescent emitter and the matrix material are evaporated in vacuum and deposited on the first electrode layer, so that an anisotropic alignment of the molecules of the phosphorescent emitter takes place, and wherein the thermodynamic control takes place by bringing the deposited emitter layer to a temperature between 30 °C and 100 °C, which is elevated with respect to room temperature, after and/or during the deposition step and before depositing a further layer, or by maintaining it at such a temperature
D) applying the second electrode layer to the emitter layer.

2. Method according to the preceding claim, wherein in step A) the phosphorescent emitter with anisotropic molecular structure is selected from iridium complexes, platinum complexes and palladium complexes and mixtures thereof.

3. Method according to the preceding claim, wherein an iridium complex of the following formula is selected: 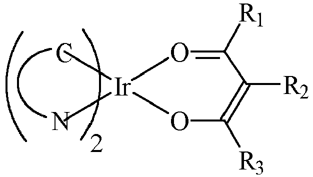 wherein CnN is an at least bidentate ligand which forms a metallacyclic ring with the Ir atom and wherein R1, R2 and R3 - independently of one another - are unbranched, branched alkyl radicals, condensed and/or ring-shaped alkyl radicals and/or aryl radicals, each of which may be fully or partially substituted and wherein R2 may also be H or F.

4. Method according to the preceding claim, wherein the ligand CnN forms a 5-membered or 6-membered metallacyclic ring with the Ir atom.

5. Method according to the preceding claim, wherein the ligand CnN is phenylpyridine, phenylimidazole, phenyloxazole, benzylpyridine, benzylimidazole, benzyloxazole or a ligand comprising one of said compounds as a backbone.

6. Method according to one of the three preceding claims, wherein the ligand CnN comprises at least 3 at least partially condensed aromatic rings.

7. Method according to one of the preceding claims, wherein the provided matrix material has an anisotropic molecular structure.

8. Method according to the preceding claim, wherein a matrix material of the type A-K-B is selected,
wherein structural element K represents a structure Ar1-X-Ar2, wherein Ar1 and Ar2 are the same or different aromatic rings and X represents a single bond, another aromatic group or a linkage of Ar1 and Ar2 by means of an annealed ring wherein structural elements A and B are the same or different and each comprise at least one aromatic ring.

9. Method according to one of the two preceding claims, wherein the groups Ar1 and Ar2 of the structural element K each represent a nitrogen heterocycle and/or the structural elements A and B each comprise an aromatically substituted amine group.

10. Method according to the preceding claim, wherein the matrix material comprises a benzidine derivative or a phenanthroline derivative.

11. Method according to one of the four preceding claims, wherein the structural elements A and B each comprise at least one aromatic substituted with a tertiary alkyl group and/or each comprise at least one condensed polycyclic aryl group.

12. Method according to one of the five preceding claims, wherein the matrix material has hole transporting and/or electron transporting properties.

## Revendications

1. Procédé de fabrication d'un dispositif électronique organique émettant un rayonnement ayant une première et une seconde couche d'électrodes et une couche d'émetteur, avec les étapes suivantes:
A) fournir un émetteur phosphorescent ayant une structure moléculaire anisotrope et un matériau de matrice,
B) déposer la première couche d'électrode sur un substrat,
C) déposer la couche d'émetteur sous contrôle thermodynamique, dans lequel l'émetteur phosphorescent et le matériau de matrice sont évaporés sous vide et déposés sur la première couche d'électrode de sorte qu'un alignement anisotrope des molécules de l'émetteur phosphorescent a lieu, et dans lequel le contrôle thermodynamique a lieu en amenant la couche d'émetteur déposée, après et/ou pendant l'étape de déposer et avant de déposer une autre couche, à une température comprise entre 30 °C et 100 °C, qui est élevée par rapport à la température ambiante, ou en la maintenant à une telle température
D) déposer la deuxième couche d'électrode sur la couche d'émetteur.

2. Procédé selon la revendication précédente, dans lequel dans l'étape A) l'émetteur phosphorescent ayant une structure moléculaire anisotrope est choisi parmi les complexes d'iridium, les complexes de platine et les complexes de palladium et leurs mélanges.

3. Procédé selon la revendication précédente, dans lequel un complexe d'iridium de la formule suivante est choisi: 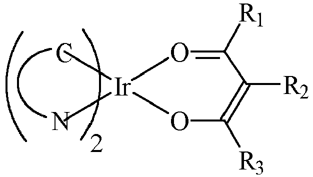 dans lequel CnN est un ligand au moins bidenté qui forme un cycle métallacyclique avec l'atome de Ir, et dans lequel R1, R2 et R3 - indépendamment les uns des autres - sont des radicaux alkyle non ramifiés, ramifiés, des radicaux alkyle condensés et/ou annulaires et/ou des radicaux aryle, chacun d'entre eux pouvant être entièrement ou partiellement substitué, et dans lequel R2 peut également être H ou F.

4. Procédé selon la revendication précédente, dans lequel le ligand CnN forme un cycle métallacyclique à 5 chaînons ou 6 chaînons avec l'atome Ir.

5. Procédé selon la revendication précédente, dans lequel le ligand CnN est la phénylpyridine, le phénylimidazole, le phényloxazole, la benzylpyridine, le benzylimidazole, le benzyloxazole ou un ligand ayant l'un desdits composés comme squelette.

6. Procédé de l'une quelconque des trois revendications précédentes, dans lequel le ligand CnN comprend au moins 3 cycles aromatiques au moins partiellement condensés.

7. Procédé selon l'une quelconque des revendications précédentes, dans lequel le matériau de matrice fourni a une structure moléculaire anisotrope.

8. Procédé selon la revendication précédente, dans lequel un matériau de matrice du type A-K-B est sélectionné,
dans lequel l'élément structurel K représente une structure Ar1-X-Ar2, dans laquelle Ar1 et Ar2 sont des cycles aromatiques identiques ou différents et X représente une liaison simple, un autre groupe aromatique ou une liaison de Ar1 et Ar2 au moyen d'un cycle annelé
dans lequel les éléments structurels A et B sont identiques ou différents et comprennent chacun au moins un cycle aromatique.

9. Procédé selon l'une ou l'autre des deux revendications précédentes, dans lequel les groupes Ar1 et Ar2 de l'élément structurel K représentent chacun un hétérocycle azoté et/ou les éléments structurels A et B comprennent chacun un groupe amine substitué aromatiquement.

10. Procédé de la revendication précédente, dans lequel le matériau de matrice comprend un dérivé de benzidine ou un dérivé de phénanthroline.

11. Procédé de l'une quelconque des quatre revendications précédentes, dans lequel les éléments structurels A et B comprennent chacun au moins un aromatique substitué par un groupe alkyle tertiaire et/ou comprennent chacun au moins un groupe aryle polycyclique condensé.

12. Procédé selon l'une quelconque des cinq revendications précédentes, dans lequel le matériau de la matrice présente des propriétés de transport de trous et/ou de transport d'électrons.
